# EUROPEAN PATENT APPLICATION

(11) **EP 4 611 038 A1**
(43) Date of publication of application: **03.09.2025**
(21) Application number: 25157413.3
(22) Date of filing: 12.02.2025
(51) Int. Cl.: H01L 23/528, H10D 84/85, H10D 88/00, H10D 89/10

(54) **SEMICONDUCTOR DEVICE INCLUDING MULTI-HEIGHT SWITCH CELL COUPLED TO MULTIPLE GLOBAL POWER RAILS**

(30) Priority: 21.02.2024 US 202463556073 P; 23.05.2024 US 202418672392
(71) Applicant: Samsung Electronics Co., Ltd., Suwon-si, Gyeonggi-do 16677 (KR)
(72) Inventor: KIM, Jintae, San Jose, CA, 95134 (US); LEE, Jaehong, San Jose, CA, 95134 (US); SEO, Kang-Ill, San Jose, CA, 95134 (US)
(74) Representative: Kuhnen & Wacker Patent- und Rechtsanwaltsbüro PartG mbB

(57) **Abstract**

Semiconductor devices are provided. A semiconductor device includes: a first stacked field-effect transistor, FET; a second stacked FET adjacent the first stacked FET; a first global back-side power rail between, and electrically connected to, the first stacked FET and the second stacked FET; a third stacked FET adjacent the second stacked FET; a local back-side power rail between, and electrically connected to, the second stacked FET and the third stacked FET; a fourth stacked FET adjacent the third stacked FET; and a second global back-side power rail between, and electrically connected to, the third stacked FET and the fourth stacked FET.

## Description

### TECHNICAL FIELD

The present disclosure generally relates to the field of semiconductor devices and, more particularly, to semiconductor devices having multi-height switch cells.

### BACKGROUND OF THE INVENTION

Integrated circuit (IC) devices, chips, and/or blocks may receive power and data signals from one or more external sources (e.g., a power source and a data source) as part of an operation. Some IC devices may receive power and data signals via front-side (FS) conductive structures. For example, an IC device may include a FS power distribution network (FSPDN) having one or more components that are formed during back end of line (BEOL) processes, and conductive structures for data signals may be on the same side of an IC device as the FSPDN. IC devices may include various transistor structures, including, for example, two-dimensional (2D) planar structures, fin field-effect transistors (FinFETs), gate-all-around transistors, multi-bridge channel FETs (MBCFETs^{™}), and stacked transistors (e.g., three-dimensional (3D) stacked transistors).

More recently, back-side PDNs (BSPDNs), in which a BS of a substrate of an IC device is used as a PDN, have also been developed. For example, a power rail may be used in a BSPDN of an IC device, and may be on a side of the substrate opposite from active components (e.g., transistors) of the IC device. Moreover, conductive structures for data signals may be on an FS of the IC device, and thus the BSPDN and the conductive structures for the data signals may be on opposite sides of the IC device.

An IC device may include multiple cells that may include transistors that are driven using a supply power. External power, however, may not be directly supplied to standard cells of the IC device. Instead, external power may be input to an element referred to as a "power-switch cell" (or "switch cell"), which generates a virtual voltage based on an external power-supply voltage. The virtual voltage output from the switch cell is applied to the standard cells. The virtual voltage may be a voltage that can be turned off, rather than a permanent, always-on voltage. A sufficient virtual voltage may need to be supplied to the standard cells for stable driving of the IC device. In addition, a ground voltage may need to be supplied to the standard cells.

The IC device may include multiple switch cells, such as metal-oxide-semiconductor (MOS)-based switch cells. The IC device may further include non-power-switch standard cells interposed between the switch cells. A standard cell may be any one of various cells for implementing a logic circuit. For example, the standard cell may provide any one of various logic gates, such as an AND gate, an OR gate, a NOR gate, an XOR gate, and a NOT gate.

### SUMMARY OF THE INVENTION

A semiconductor device, according to some embodiments herein, may include a first stacked FET. The semiconductor device may include a second stacked FET adjacent the first stacked FET. The semiconductor device may include a first global back-side power rail between, and electrically connected to, the first stacked FET and the second stacked FET. The semiconductor device may include a third stacked FET adjacent the second stacked FET. The semiconductor device may include a local back-side power rail between, and electrically connected to, the second stacked FET and the third stacked FET. The semiconductor device may include a fourth stacked FET adjacent the third stacked FET. Moreover, the semiconductor device may include a second global back-side power rail between, and electrically connected to, the third stacked FET and the fourth stacked FET.

A semiconductor device, according to some embodiments herein, may include a multi-height switch cell having at least a quad cell height. The semiconductor device may include global back-side power rails and local back-side power rails that are electrically connected to the multi-height switch cell. Moreover, the global back-side power rails may alternate with the local back-side power rails along a height direction of the multi-height switch cell.

A semiconductor device, according to some embodiments herein, may include a multi-height gating cell having at least a quad cell height. The semiconductor device may include a BSPDN that is electrically connected to the multi-height power-gating cell. Moreover, the BSPDN may include a first always-on back-side power rail and a second always-on back-side power rail that are each electrically connected to the multi-height power-gating cell.

### BRIEF DESCRIPTION OF THE DRAWINGS

FIG. 1A is a schematic block diagram of a device according to some embodiments herein.
FIG. 1B is a schematic block diagram of a switch cell and standard cells of the IC of FIG. 1A.
FIG. 1C is a schematic block diagram of a BSPDN of the IC of FIG. 1A.
FIGs. 1D and 1E are example block diagrams of a switch cell of FIG. 1C.
FIG. 1F is an example plan view of the switch cell, standard cells, and BSPDN of FIG. 1C.
FIG. 1G is an enlarged plan view of the switch cell of FIG. 1F.
FIG. 1H is a cross-sectional view along the line A-A' of FIG. 1G.
FIG. 1I is a cross-sectional view along the line B-B' of FIG. 1G.
FIG. 2 is another example plan view of the switch cell of FIG. 1C.

### DETAILED DESCRIPTION

A semiconductor device may include a switch cell that can control power consumption of a block or chip. Performance of the switch cell can thus be important. The switch cell can transfer a voltage of a global, always-on power rail to a local power rail that is connected to a normal (i.e., non-power-switch) standard cell. A gate switch may be controlled when a block needs to turn on. Moreover, performance of the device may vary based on a location of the global power rail within a BSPDN.

For example, when the global power rail is at the center of a multi-height switch cell, a relatively long contact may be used to connect the global power rail to each height of the multi-height switch cell. The long contact may increase the risk of a short between the long contact and an adjacent gate structure that extends in parallel with the long contact, due to challenges with fabricating (e.g., patterning) the long contact. The long contact may also result in a high capacitance between the long contact and the gate structure, which can reduce performance of the multi-height switch cell.

Pursuant to embodiments herein, however, semiconductor (e.g., semiconductor IC) devices are provided that include a multi-height switch cell that is coupled to a BSPDN in which global power rails alternate with local power rails. As a result, shorter contacts can be used to electrically connect the global power rails to transistors in the multi-height switch cell.

As an example, a quad-height switch cell may have four stacked FETs, where each stacked FET includes a p-type MOS (PMOS) transistor in a stack with an n-type MOS (NMOS) transistor. In contrast with a conventional global power rail that is at (e.g., aligned with) the center of the quad-height switch cell and is coupled to a conventional long contact that contacts all four of the PMOS transistors, embodiments herein provide a first global power rail between a first and a second of the PMOS transistors and a second global power rail between a third and a fourth of the PMOS transistors. A first contact can electrically connect the first global power rail to the first and the second of the PMOS transistors, and a second contact can electrically connect the second global power rail to the third and the fourth of the PMOS transistors. The first contact and the second contact are individually and collectively shorter (and therefore include less metal and may be easier to pattern) than the conventional long contact, and thus can reduce the risk of a short between the contacts and an adjacent gate structure and can reduce a capacitance between the contacts and the gate structure. The shorter contacts can thus improve performance of the multi-height switch cell.

Some examples of embodiments of the present disclosure will be described in greater detail with reference to the attached figures.

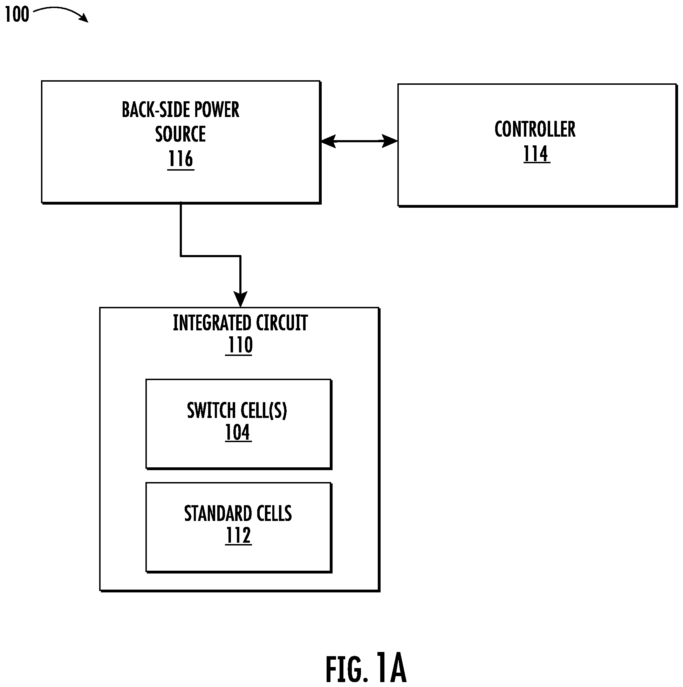

FIG. 1A is a schematic block diagram of a device 100 according to some embodiments herein. The device 100 includes an IC 110, which has normal standard cells 112 (e.g., blocks) and one or more switch cells 104. For example, a switch cell 104 may be a complementary MOS (CMOS) switch cell comprising a PMOS transistor and an NMOS transistor.

The device 100 also includes a BS power source 116 that is coupled to the IC 110. The BS power source 116 may provide power signals to the IC 110 at one or more voltage levels. As an example, the BS power source 116 may be configured to provide one or more voltages between 0.4-1.1 volts.

The device 100 further includes a controller 114 that is coupled to the BS power source 116. The controller 114 may include one or more microprocessors that are configured to control operations of the BS power source 116. For example, the controller 114 may include a microprocessor that is configured to turn the BS power source 116 on or off. The controller 114 and BS power source 116 may be used to perform chip-level power gating (e.g., turning on or off the entire IC 110) and/or block-level power gating (e.g., turning on or off individual portions of the IC 110, such as the switch cell(s) 104). As shown in FIG. 1A, the controller 114 may be external to (i.e., outside of) the IC 110 that includes the switch cell(s) 104 and the standard cells 112.

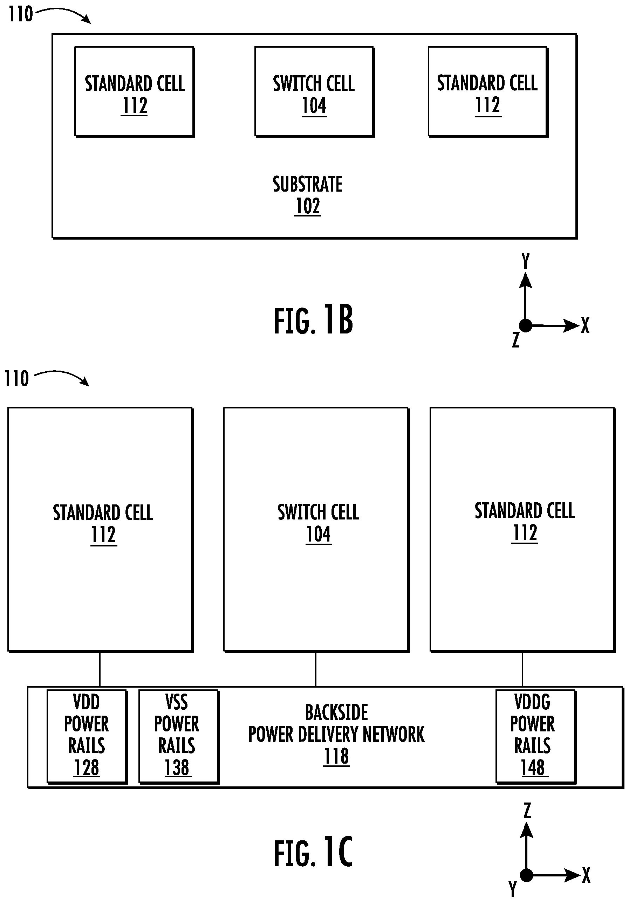

FIG. 1B is a schematic block diagram of a switch cell 104 and standard cells 112 of the IC 110. The switch cell 104 includes transistors that are in (and/or on) a substrate 102. For example, the switch cell 104 may include at least one stacked FET, in which a PMOS transistor and an NMOS transistor are in a vertical stack in (and/or on) the substrate 102. As an example, the PMOS transistor may be on top of (i.e., may vertically overlap) the NMOS transistor. Accordingly, an axis that extends in a vertical (Z) direction passes through both the PMOS transistor and the NMOS transistor.

In some embodiments, the switch cell 104 may be between a pair of the standard cells 112 in a first horizontal (X) direction and/or in a second horizontal (Y) direction. The standard cells 112 may be referred to herein as "normal" standard cells to distinguish them from the switch cells 104. The standard cells 112 thus may not be switch cells, and therefore may not be configured to transfer a voltage of a global power rail to a local power rail.

FIG. 1C is a schematic block diagram of a BSPDN 118 of the IC 110. As shown in FIG. 1C, the BSPDN 118 includes local power rails 128, global power rails 148, and source-supply power rails 138 that are on a BS of the IC 110. Because they are part of the BSPDN 118, the local power rails 128, the global power rails 148, and the source-supply power rails 138 may also be referred to herein as "back-side" power rails, each of which may be provided by a respective metal line on a BS of the substrate 102 (FIG. 1B) of the IC 110. For simplicity of illustration, the substrate 102 is omitted from view in FIG. 1C.

A local power rail 128 may provide a virtual voltage (virtual VDD) to a standard cell 112, where the virtual voltage is output to the local power rail 128 by a switch cell 104. The virtual voltage may be generated by the switch cell 104 based on a global, always-on voltage (VDDG) that is supplied to a global power rail 148 by an external power source, such as the BS power source 116 (FIG. 1A). The local power rail 128 may thus also be referred to herein as a "normal" or "virtual" (or "virtual-voltage") power rail, and the power rail 148 may also be referred to herein as an "always-on" power rail. A source-supply power rail 138 may transmit power, such as a source-supply (e.g., negative power supply) voltage VSS to the switch cell 104. For example, VSS may be zero volts.

In some embodiments, the switch cell 104 may overlap, in the direction Z, multiple global power rails 148, multiple local power rails 128, and multiple source-supply power rails 138. As an example, the switch cell 104 may be a multi-height switch cell that is electrically connected to multiple global power rails 148. For example, the multi-height switch cell may include at least four PMOS transistors, and pairs of the PMOS transistors may be electrically connected to respective ones of the global power rails 148.

Moreover, some of the local power rails 128 may be electrically connected to multiple standard cells 112, in addition to being electrically connected to the switch cell 104. As an example, some of the local power rails 128 may extend longitudinally in the direction X and may be electrically connected to two standard cells 112 that are spaced apart from each other in the direction X.

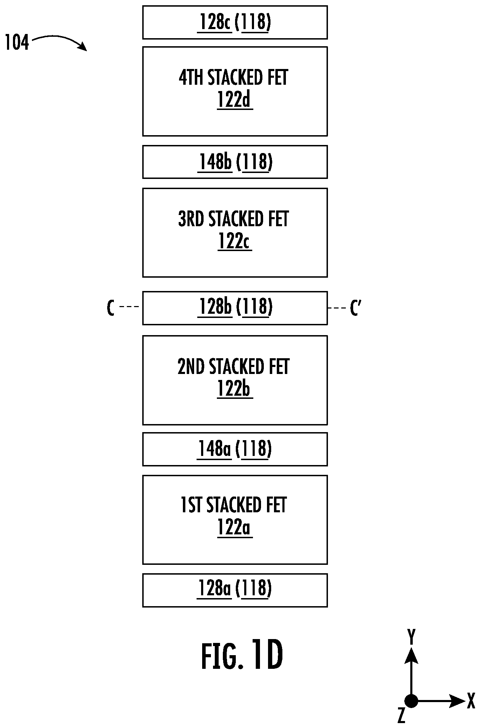

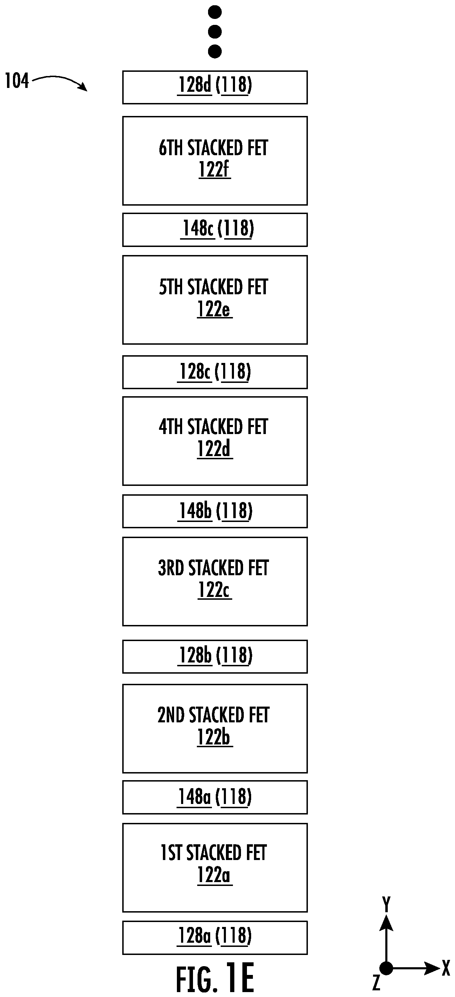

FIGs. 1D and 1E are example block diagrams of a switch cell 104. FIG. 1D shows an example in which the switch cell 104 has a quad cell height in the direction Y, which is provided by four stacked FETs 122a-122d. FIG. 1E shows an example in which the switch cell 104 has more than a quad cell height.

As shown in FIG. 1D, a BSPDN 118 includes local power rails 128 and global power rails 148 that alternate with each other along the direction Y. A middle (second) local power rail 128b is at a center point, in the direction Y, of the switch cell 104. The center point is a point along a line C-C', which is between, in the direction Y, the second stacked FET 122b and the third stacked FET 122c. The local power rail 128b can be aligned with the line C-C'. Also, local power rails 128a, 128c are at opposite ends of the switch cell 104. The three local power rails 128a, 128b, 128c are each electrically connected to the switch cell 104. Moreover, two global power rails 148a, 148b are electrically connected to the switch cell 104. The number of global power rails 148 electrically connected to the switch cell 104 is thus one fewer than the number of local power rails 128 electrically connected to the switch cell 104.

The first global power rail 148a is between (and electrically connected to), in the direction Y, the first stacked FET 122a and the second stacked FET 122b. The first global power rail 148a is also between, in the direction Y, the first and second local power rails 128a, 128b. The second global power rail 148b is between (and electrically connected to), in the direction Y, the third stacked FET 122c and the fourth stacked FET 122d. The second global power rail 148b is also between, in the direction Y, the second and third local power rails 128b, 128c.

The first through fourth stacked FETs 122a-122d are consecutive stacked FETs in the direction Y. The first stacked FET 122a is adjacent the second stacked FET 122b in the direction Y. The third stacked FET 122c is adjacent the second stacked FET 122b in the direction Y. The fourth stacked FET 122d is adjacent the third stacked FET 122c in the direction Y. As used herein with respect to the stacked FETs 122, the term "adjacent" means that no other stacked FET 122 intervenes between two stacked FETs 122.

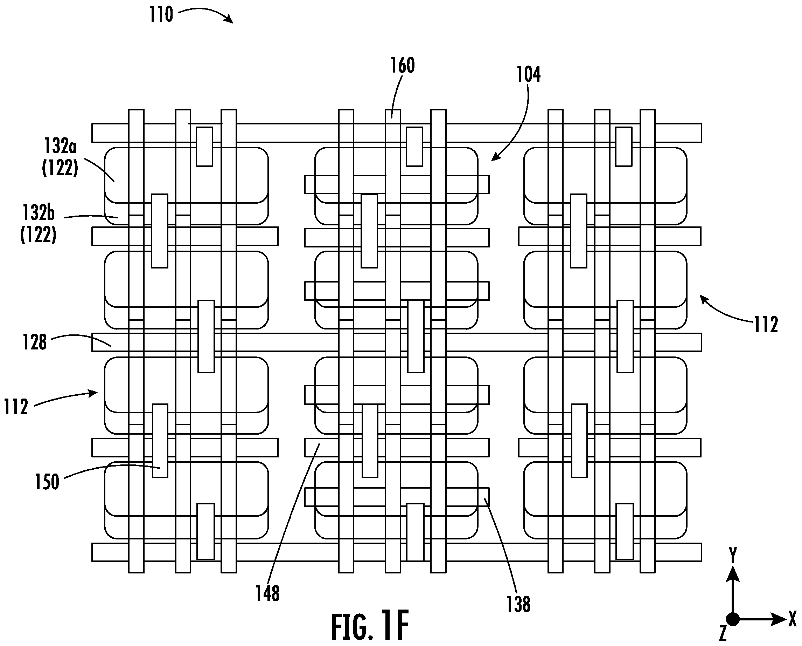

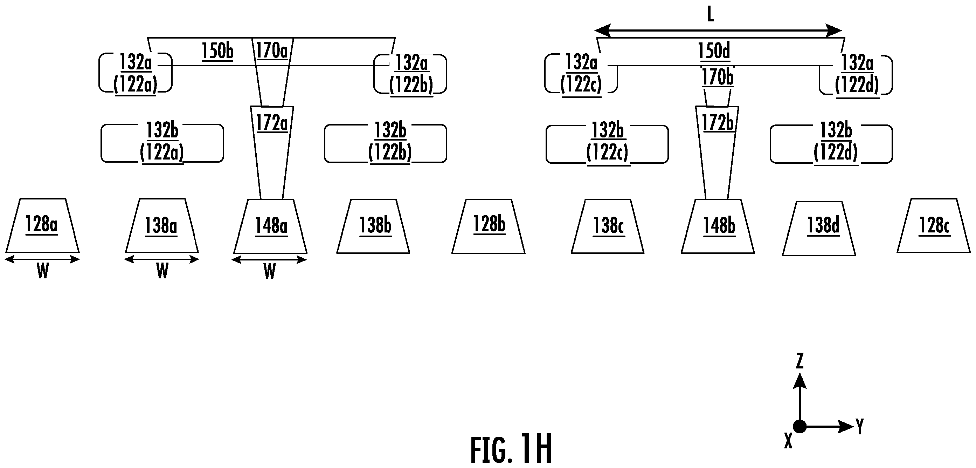

Moreover, for simplicity of description, the term "between" may be used herein, with respect to a power rail and adjacent stacked FETs 122, to describe the horizontal position of the power rail as it appears in the block diagram of FIG. 1D and as shown in further detail in the plan view of FIG. 1F. It will be understood, however, that the BSPDN 118, and thus the power rails therein, is at a different vertical level from that of the stacked FETs 122. Accordingly, the term "between," as used herein with respect to a power rail and adjacent stacked FETs 122, does not require that an axis extends in the direction Y through the power rail and the adjacent stacked FETs 122 in the cross-sectional view of FIG. 1H. Rather, it is sufficient that an axis extends in the direction Y through the power rail and the adjacent stacked FETs 122 in the plan view of FIG. 1F.

The stacked FETs 122 may transfer a voltage of the global power rails 148 to the local power rails 128. For example, the first stacked FET 122a may be configured to transfer a voltage of the first global power rail 148a to the first local power rail 128a, and the second stacked FET 122b may be configured to transfer a voltage of the first global power rail 148a to the second local power rail 128b. Moreover, the third stacked FET 122c may be configured to transfer a voltage of the second global power rail 148b to the second local power rail 128b, and the fourth stacked FET 122d may be configured to transfer a voltage of the second global power rail 148b to the third local power rail 128c.

As shown in FIG. 1E, a switch cell 104 can include more than four stacked FETs 122. For example, the switch cell 104 may include a fifth stacked FET 122e and a sixth stacked FET 122f. Moreover, the BSPDN 118 may include a third global power rail 148c and a fourth local power rail 128d that are electrically connected to the switch cell 104. The fifth stacked FET 122e is between, in the direction Y, the third local power rail 128c and the third global power rail 148c. The sixth stacked FET 122f is between, in the direction Y, the third global power rail 148c and the fourth local power rail 128d. The number of global power rails 148 electrically connected to the switch cell 104 is thus one fewer than the number of local power rails 128 electrically connected to the switch cell 104.

For simplicity of illustration, only six stacked FETs 122 are shown in FIG. 1E. In some embodiments, however, the switch cell 104 may include eight, ten, twelve, or more stacked FETs 122, and thus may have a cell height of eight, ten, twelve, or more. As the cell height increases in the direction Y, additional local power rails 128 and global power rails 148 will alternate with each other in the direction Y, continuing the pattern that is shown in FIG. 1E. The switch cell 104 may include three, four, five, six, or more pairs of stacked FETs 122, and each pair may be electrically connected to a respective global power rail 148.

FIG. 1F is an example plan view of the switch cell 104, standard cells 112, and BSPDN 118 of the IC 110 of FIG. 1C. In some embodiments, the switch cell 104 and the standard cells 112 may each be quad-height cells having four stacked FETs 122 along the direction Y. In other embodiments, the standard cells 112 may include components (e.g., logic gates) other than stacked FETs 122. Each stacked FET 122 may include a PMOS region 132a that is in a vertical stack with an NMOS region 132b.

The switch cell 104 may be electrically connected to multiple local power rails 128, multiple source-supply power rails 138, and multiple global power rails 148. According to some embodiments, ones of the local power rails 128 that are electrically connected to the switch cell 104 may extend continuously in the direction X so that they are also electrically connected to both standard cells 112. For example, those local power rails 128 may extend in parallel with stacked FETs 122 of each of the standard cells 112. The switch cell 104 may be configured to transfer a voltage of the global power rails 148 to those local power rails 128 (and thereby to the standard cells 112). Each standard cell 112 may also be electrically connected to two shorter local power rails 128 that are collinear (in the direction X) with, and separated from, the global power rails 148 and are only overlapped (in the direction Z) by a single standard cell 112. Unlike the switch cell 104, however, the standard cells 112 may not overlap (in the direction Z) any global power rails 148 and may not overlap (in the direction Z) any source-supply power rails 138. Moreover, the standard cells 112 and the switch cell 104 may each be overlapped (in the direction Z) by contacts 150 and gate structures 160 that extend longitudinally in the direction Y in parallel with each other.

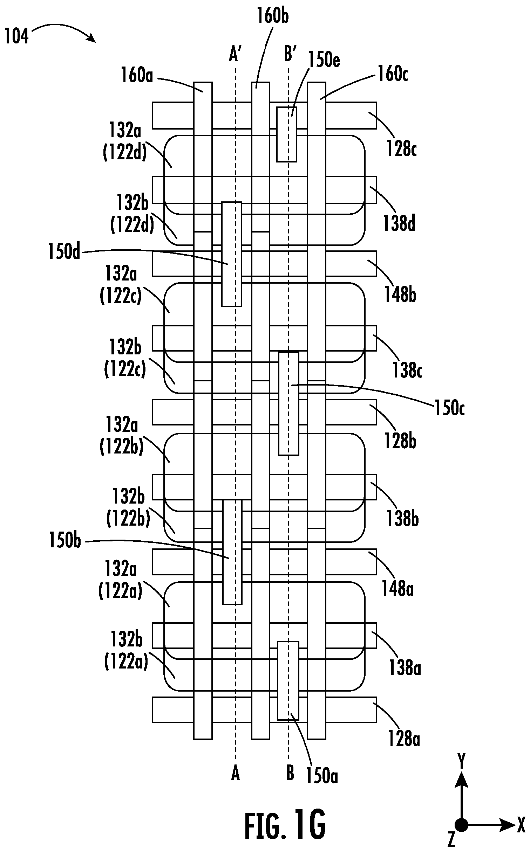

FIG. 1G is an enlarged plan view of the switch cell 104 of FIG. 1F. As shown in FIG. 1G, each global power rail 148 may be electrically connected to the switch cell 104 by a respective contact 150. Similarly, local power rails 128 may be electrically connected to the switch cell 104 by respective contacts 150.

For example, the first global power rail 148a may be electrically connected to the first and second stacked FETs 122a, 122b by a contact 150b. The second global power rail 148b may be electrically connected to the third and fourth stacked FETs 122c, 122d by another contact 150d. Moreover, the first local power rail 128a may be electrically connected to the first stacked FET 122a by a contact 150a, the second local power rail 128b may be electrically connected to the second and third stacked FETs 122b, 122c by a contact 150c, and the third local power rail 128c may be electrically connected to the fourth stacked FET 122d by a contact 150e. The contacts 150a-150e may each be relatively-short contacts that do not overlap each other in the direction X.

Each of three gate structures 160a-160c may extend continuously in the direction Y such that it overlaps all four of the stacked FETs 122a-122d in the direction Z. In contrast, each contact 150 may be relatively short. As an example, each contact 150 may overlap no more than two of the stacked FETs 122 in the direction Z. Moreover, each contact 150 may overlap, in the direction Z, no more than half of a width, in the direction Y, of a stacked FET 122. For example, the contact 150b may overlap, in the direction Z, less than half of a width, in the direction Y, of the first stacked FET 122a, and less than half of a width, in the direction Y, of the second stacked FET 122b.

Because the contacts 150 are relatively short in length, the risk of an electrical short between the contacts 150 and adjacent ones of the gate structures 160a-160c may be reduced (as the short contacts 150 may be easier to pattern than long contacts), and a capacitance between the contacts 150 and the gate structures 160a-160c may be reduced (due to less metal in the short contacts 150). The short lengths of the contacts 150 are facilitated by having multiple global power rails 148 that are electrically connected to the switch cell 104 by respective contacts 150, instead of having one centralized global power rail that is electrically connected to the switch cell 104 by a single, long contact.

FIG. 1G also shows that the stacked FETs 122 each include a PMOS transistor 132a that is in a vertical transistor stack with an NMOS transistor 132b. In some embodiments, the PMOS transistor 132a may be stacked on top of the NMOS transistor 132b. Moreover, the PMOS transistor 132a may be wider, in the direction Y, than the NMOS transistor 132b.

According to some embodiments, each stacked FET 122 may overlap, in the direction Z, a respective source-supply power rail 138 of the BSPDN 118 (FIG. 1C). The source-supply power rails 138 may extend longitudinally in the direction X in parallel with the local power rails 128 and the global power rails 148. A first source-supply power rail 138a may be centered, in the direction Y, between (i.e., equidistant from) the first local power rail 128a and the first global power rail 148a. A second source-supply power rail 138b may be centered, in the direction Y, between the first global power rail 148a and the second local power rail 128b. A third source-supply power rail 138c may be centered, in the direction Y, between the second local power rail 128b and the second global power rail 148b. A fourth source-supply power rail 138d may be centered, in the direction Y, between the second global power rail 148b and the third local power rail 128c.

FIG. 1H is a cross-sectional view along the line A-A' of FIG. 1G. As shown in FIG. 1H, the power rails 128, 138, 148 may all have the same width W in the direction Y. Also, the contacts 150b, 150d may each have a length L in the direction Y that is less than a pitch in the direction Y between a pair of PMOS transistors 132a that are electrically connected to the same global power rail 148. FIG. 1H shows that the first global power rail 148a is electrically connected to a PMOS transistor 132a of the first stacked FET 122a and a PMOS transistor 132a of the second stacked FET 122b by a contact 150b.

For example, the contact 150b may be in contact with a source/drain (S/D) region of the PMOS transistor 132a of the first stacked FET 122a and an S/D region of the PMOS transistor 132a of the second stacked FET 122b. Similarly, the second global power rail 148b is electrically connected to a PMOS transistor 132a (e.g., an S/D region thereof) of the third stacked FET 122c and a PMOS transistor 132a (e.g., an S/D region thereof) of the fourth stacked FET 122d by a contact 150d. For example, the contact 150d may be in contact with an S/D region of the PMOS transistor 132a of the third stacked FET 122c and an S/D region of the PMOS transistor 132a of the fourth stacked FET 122d. The contact 150b, on the other hand, is not in contact with the third stacked FET 122c and is not in contact with the fourth stacked FET 122d. Likewise, the contact 150d is not in contact with the first stacked FET 122a and is not in contact with the second stacked FET 122b.

The first global power rail 148a may be electrically connected to the contact 150b by an upper via 170a and a lower via 172a. Likewise, the second global power rail 148b may be electrically connected to the contact 150d by an upper via 170b and a lower via 172b. In some embodiments, the upper vias 170 and the lower vias 172 may be in the substrate 102 (FIG. 1B). For simplicity of illustration, however, the substrate 102 is omitted from view in FIG. 1H.

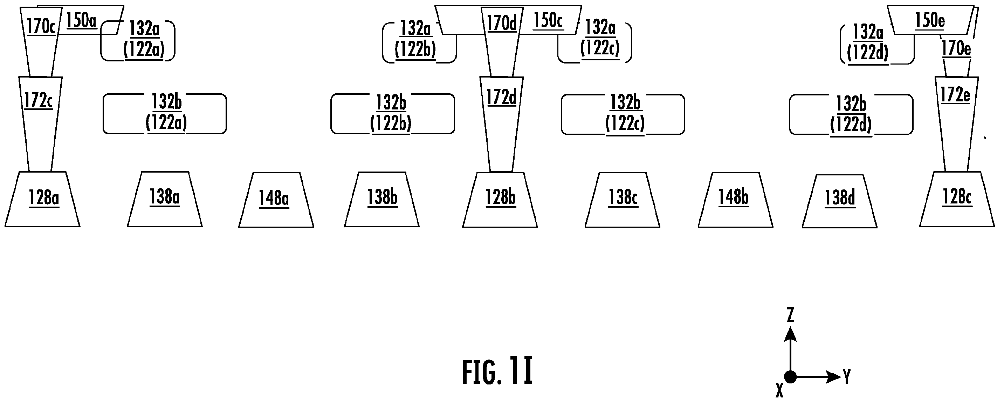

FIG. 1I is a cross-sectional view along the line B-B' of FIG. 1G. As shown in FIG. 1I, the local power rails 128a, 128b, 128c are electrically connected to the contacts 150a, 150c, 150e, respectively. The contact 150a may be in contact with a PMOS transistor 132a of the first stacked FET 122a, the contact 150c may be in contact with both a PMOS transistor 132a of the second stacked FET 122b and a PMOS transistor 132a of the third stacked FET 122c, and the contact 150e may be in contact with a PMOS transistor 132a of the fourth stacked FET 122d. Upper vias 170 and lower vias 172 may be coupled between the local power rails 128 and the contacts 150. As an example, the first local power rail 128a may be electrically connected to the contact 150a by an upper via 170c and a lower via 172c. Similarly, the second local power rail 128b may be electrically connected to the contact 150c by an upper via 170d and a lower via 172d, and the third local power rail 128c may be electrically connected to the contact 150e by an upper via 170e and a lower via 172e.

In some embodiments, the upper vias 170 and the lower vias 172 may be in the substrate 102 (FIG. 1B). For simplicity of illustration, however, the substrate 102 is omitted from view in FIG. 1I.

The first local power rail 128a is electrically connected to a PMOS transistor 132a (e.g., is in contact with an S/D region thereof) of the first stacked FET 122a by the contact 150a. The second local power rail 128b is electrically connected to a PMOS transistor 132a (e.g., an S/D region thereof) of the second stacked FET 122b and a PMOS transistor 132a (e.g., an S/D region thereof) of the third stacked FET 122c by the contact 150c. Moreover, the third local power rail 128c is electrically connected to a PMOS transistor 132a (e.g., is in contact with an S/D region thereof) of the fourth stacked FET 122d by the contact 150e.

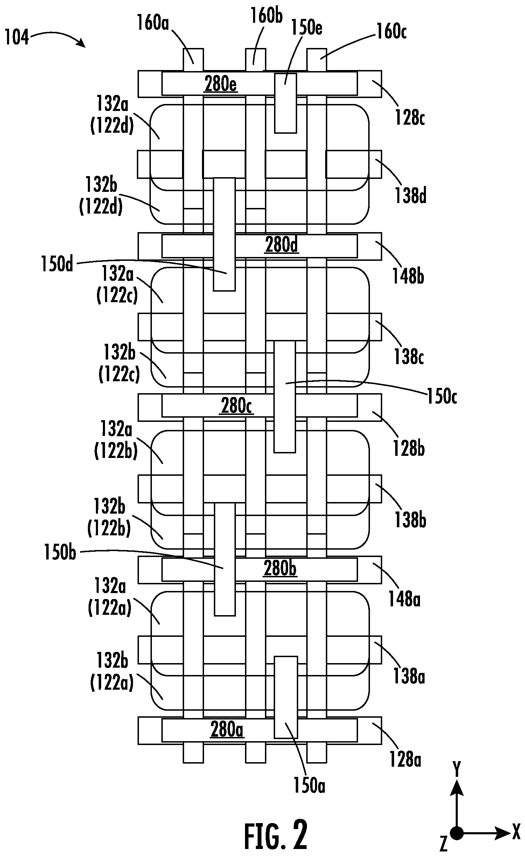

FIG. 2 is another example plan view of the switch cell 104 of FIG. 1C. As shown in FIG 2, the gate structures 160 may have gate-cuts 280 therein. For example, the gate-cuts 280 may extend longitudinally in the direction X through each of the gate structures 160a-160c. Each gate-cut 280 may include an insulating material (e.g., silicon nitride) that electrically isolates a first portion of a gate structure 160 from a second portion of the gate structure 160. As an example, a gate-cut 280b is between, in the direction Y, the first stacked FET 122a and the second stacked FET 122b, and may electrically isolate portions of the gate structures 160 that are electrically connected to first stacked FET 122a from portions of the gate structures 160 that are electrically connected to second stacked FET 122b.

Though FIG. 2 shows an example in which the switch cell 104 includes four stacked FETs 122a-122d and the gate structures 160 are divided by five gate-cuts 280a-280e, other switch cells 104 may have more than four stacked FETs 122, and thus more than five gate-cuts 280. In some embodiments, the number of gate-cuts 280 may be one more than the number of stacked FETs 122 in the switch cell 104.

According to some embodiments, gate-cuts 280 may electrically isolate different portions of gate structures 160 that vertically overlap standard cells 112 (FIG. 1F). As an example, gate-cuts 280 may be provided between stacked FETs 122 of the standard cells 112. For simplicity of illustration, the standard cells 112 that are shown in FIG. 1F are omitted from view in FIG. 2. It will be understood, however, that gate-cuts 280 may be provided for any of the gate structures 160 shown in FIG. 1F.

Devices 100 (FIG. 1A) according to some embodiments herein may provide a number of advantages. These advantages may include reduced risk of an electrical short between a contact and an adjacent gate structure. This reduced risk of a short may be provided by using contacts 150 (FIG. 1G) that are relatively short in length, and thus may be easier to form (e.g., pattern) than long contacts. The shorter contacts 150 may be facilitated by using a BSPDN 118 (FIG. 1C) in which multiple global power rails 148 (FIG. 1G) are electrically connected to a switch cell 104 (FIG. 1G), instead of using a single, centralized global power rail. The advantages may also include reduced capacitance between a contact and an adjacent gate structure. This reduced capacitance may be provided by the relatively-short contacts 150 (which have less metal than long contacts), and can improve performance of a device 100. For example, the global power rails 148 may alternate with local power rails 128 (FIG. 1G) along a cell-height direction of a multi-height switch cell, and can thereby mitigate electrical-short and high-capacitance problems that can occur when using a longer contact with a single, centralized global power rail.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and the appended claims are intended to cover all such modifications, enhancements, and other embodiments, which fall within the scope of the present invention. Thus, to the maximum extent allowed by law, the scope is to be determined by the broadest permissible interpretation of the following claims and their equivalents, and shall not be restricted or limited by the foregoing detailed description.

## Claims

1. A semiconductor device comprising:
a first stacked field-effect transistor, FET;
a second stacked FET adjacent the first stacked FET;
a first global back-side power rail between, and electrically connected to, the first
stacked
FET and the second stacked FET;
a third stacked FET adjacent the second stacked FET;
a local back-side power rail between, and electrically connected to, the second stacked FET and the third stacked FET;
a fourth stacked FET adjacent the third stacked FET; and
a second global back-side power rail between, and electrically connected to, the third stacked FET and the fourth stacked FET.

2. The semiconductor device of Claim 1, further comprising a contact that is in contact with both a transistor of the first stacked FET and a transistor of the second stacked FET,
wherein the first global back-side power rail is electrically connected to the transistor of the first stacked FET and the transistor of the second stacked FET via the contact, and
wherein the second stacked FET is configured to transfer a voltage of the first global back-side power rail to the local back-side power rail.

3. The semiconductor device of Claim 2, wherein the contact is not in contact with the third stacked FET and is not in contact with the fourth stacked FET.

4. The semiconductor device of Claim 2 or 3, further comprising a second contact that is in contact with both a transistor of the third stacked FET and a transistor of the fourth stacked FET,
wherein the second global back-side power rail is electrically connected to the transistor of the third stacked FET and the transistor of the fourth stacked FET via the second contact.

5. The semiconductor device of any one of Claims 2 to 4,
wherein the transistor of the first stacked FET and the transistor of the second stacked FET are respective p-type metal-oxide-semiconductor, PMOS, transistors,
wherein the PMOS transistor of the first stacked FET is on top of an n-type metal-oxide-semiconductor, NMOS, transistor of the first stacked FET, and
wherein the PMOS transistor of the second stacked FET is on top of an NMOS transistor of the second stacked FET.

6. The semiconductor device of Claim 1, further comprising a contact that is in contact with both a transistor of the second stacked FET and a transistor of the third stacked FET,
wherein the local back-side power rail is electrically connected to the transistor of the second stacked FET and the transistor of the third stacked FET via the contact.

7. The semiconductor device of any one of Claims 1 to 6, further comprising a second local back-side power rail,
wherein the first stacked FET is adjacent, and electrically connected to, the second local back-side power rail.

8. The semiconductor device of any one of Claims 1 to 7, wherein the first global back-side power rail and the second global back-side power rail are respective always-on back-side power rails.

9. The semiconductor device of any one of Claims 1 to 8, further comprising:
a first gate-cut between the first stacked FET and the second stacked FET;
a second gate-cut between the second stacked FET and the third stacked FET; and
a third gate-cut between the third stacked FET and the fourth stacked FET.

10. The semiconductor device of any one of Claims 1 to 6, wherein the first stacked FET, the second stacked FET, the third stacked FET, and the fourth stacked FET are consecutive stacked FETs in a multi-height power-switch cell.

11. The semiconductor device of Claim 10, wherein the multi-height power-switch cell comprises more than four stacked FETs.

12. The semiconductor device of Claim 11, further comprising:
a fifth stacked FET, of the multi-height power-switch cell, adjacent the fourth stacked FET; and
a second local back-side power rail between the fourth stacked FET and the fifth stacked FET.

13. The semiconductor device of any one of Claims 10 to 12, further comprising a pair of non-power-switch standard cells,
wherein the multi-height power-switch cell is between the pair of non-power-switch standard cells, and
wherein the local back-side power rail is electrically connected to each non-power-switch standard cell among the pair of non-power-switch standard cells.

14. The semiconductor device of Claim 1,
wherein the first global back-side power rail, the second global back-side power rail, and the local back-side power rail each extend longitudinally in a first direction, and are spaced apart from each other in a second direction that is perpendicular to the first direction, and
wherein a width, in the second direction, of the first global back-side power rail is equal to a width, in the second direction, of the second global back-side power rail, and is equal to a width, in the second direction, of the local back-side power rail.

15. The semiconductor device of Claim 14, further comprising:
a first contact that is on the first global back-side power rail;
a second contact that is on the second global back-side power rail; and
a third contact that is on the local back-side power rail,
wherein the first contact and the second contact do not overlap the third contact in the first direction.
